## Europäisches Patentamt
## European Patent Office
## Office européen des brevets

(19)

(11) Veröffentlichungsnummer : **0 046 962**
**B1**

(12)

# EUROPÄISCHE PATENTSCHRIFT

(45) Veröffentlichungstag der Patentschrift : 08.02.84

(51) Int. Cl.³ : **H 03 K 17/08**

(21) Anmeldenummer : 81106563.0

(22) Anmeldetag : 24.08.81

(54) Schutzschaltung für einen Schalttransistor.

(30) Priorität : 01.09.80 DE 3032888

(43) Veröffentlichungstag der Anmeldung : 10.03.82 Patentblatt 82/10

(45) Bekanntmachung des Hinweises auf die Patenterteilung : 08.02.84 Patentblatt 84/06

(84) Benannte Vertragsstaaten : BE CH DE FR GB IT LI SE

(56) Entgegenhaltungen :
FR-A- 1 453 559
US-A- 3 962 601
US-A- 4 041 327
ELECTRONICS, Band 48, Nr. 12, 12. Juni 1975, Seiten 101-103 New York, U.S.A., R.M. STITT: "Current and power limiter protects switching transistor"

(73) Patentinhaber : SIEMENS AKTIENGESELLSCHAFT Berlin und München Wittelsbacherplatz 2 D-8000 München 2 (DE)

(72) Erfinder : Steinigeweg, Rolf-Jürgen Eskilstunastrasse 33 D-8520 Erlangen (DE)

Schutzschaltung für einen Schalttransistor

Die Erfindung betrifft eine Schutzschaltung für einen über einen Übertrager angesteuerten Schalttransistor mit einem zur Basis-Emitter-Strecke parallel liegenden Halbleiterschalter, der bei Überstrom in der Kollektor-Emitter-Strecke des Schalttransistors eingeschaltet wird, wobei zwischen Basis und Kollektor des Schalttransistors die Reihenschaltung eines Widerstands und einer Diode angeordnet ist, die in bezug auf die Kollektorspannung des Schalttransistors in Sperrichtung gepolt ist, und wobei der Verbindungspunkt zwischen Widerstand und Diode über einen Kondensator mit dem Bezugspotential der Schaltungsanordnung und über ein Schwellwertglied mit dem Steuereingang des Halbleiterschalters verbunden ist. Eine derartige Schutzschaltung ist aus der FR-PS 14 53 559 bekannt. Dabei wird das Ansteigen der Kollektor-Emitter-Spannung des Schalttransistors als Kriterium für das Auftreten eines Überstroms benutzt. Sobald die Kollektor-Emitter-Spannung des Schalttransistors den Schwellwert des Schwellwertglieds übersteigt, wird der Halbleiterschalter eingeschaltet und schließt die Basis-Emitter-Strecke des Schalttransistors kurz. Damit erhält der Schalttransistor keinen Basisstrom mehr, so daß der Kollektor-Emitter-Strom annähernd auf Null zurückgeht. Bei der bekannten Anordnung ist keine Anzeige dafür vorgesehen, daß die Schutzeinrichtung angesprochen hat.

Aus der US-PS 40 41 327 ist eine Überwachungsschaltung bekannt, die den Schaltzustand eines Halbleiterschalters überwacht. Dabei werden über einen Übertrager Prüfsignale gegeben, mit denen der Schaltzustand des Halbleiterschalters abgefragt wird. Würde man eine derartige Abfrageeinrichtung für eine Schutzschaltung der eingangs genannten Art einsetzen, so würde dies einen verhältnismäßig großen Aufwand für die Erzeugung der Prüfimpulse bedeuten.

Aufgabe der Erfindung ist es daher, eine Schutzschaltung der eingangs genannten Art so auszugestalten, daß das Auftreten eines Überstromes durch Erfassung des Schaltzustands der Schutzschaltung ohne gesonderte Abfrageimpulse festgestellt werden kann.

Diese Aufgabe wird erfindungsgemäß dadurch gelöst, daß jeder Ansteuerimpuls auf der Primärseite des Übertragers mit einer Referenzspannung verglichen wird und daß bei Unterschreitung der Referenzspannung ein Störsignal abgegeben wird. Damit kann das Ansprechen der Schutzschaltung auf der Primärseite des Übertragers erfaßt werden, da die Spannung auf der Primärseite bei Ansprechen der Schutzschaltung, d. h. bei durchgesteuertem Halbleiterschalter, sehr klein wird.

Vorteilhafterweise ist zwischen dem Widerstand und der Basis des Schalttransistors eine Z-Diode angeordnet. Damit steht bei angesteuertem Schalttransistor an der Reihenschaltung des Widerstandes und der Diode die Summe der Basis-Emitterspannung des Schalttransistors und der Zenerspannung der Z-Diode an, so daß die Spannung zur Ansteuerung des Halbleiterschalters höher angesetzt werden kann.

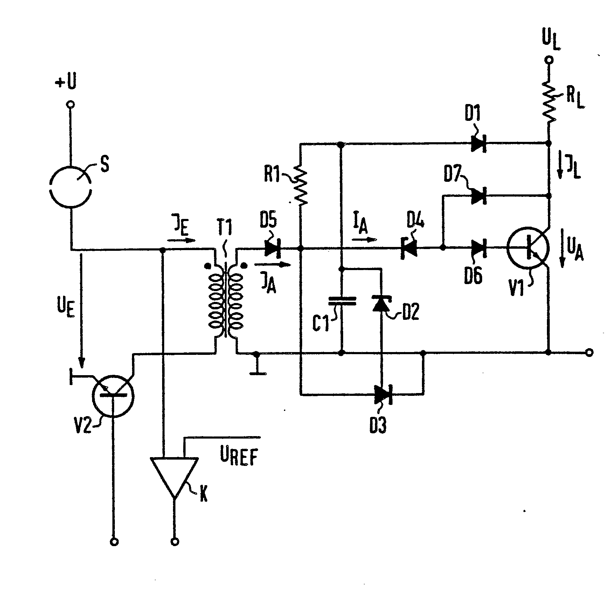

Ein Ausführungsbeispiel der Erfindung wird im folgenden anhand der Figur erläutert.

Die Figur zeigt einen Schalttransistor V1, der über einen Übertrager T1 angesteuert wird. Die Primärseite des Übertragers T1 liegt in Reihe mit einem Ansteuertransistor V2 an einer Konstantstromquelle S. Die Sekundärwicklung des Übertragers T1 ist einerseits mit dem Emitter des Schalttransistors V1 und andererseits über eine Ansteuerdiode D5, eine Z-Diode D4 und eine weitere Diode D6 mit der Basis des Schalttransistors V1 verbunden. Zwischen dem Kollektor des Schalttransistors V1 und dem Verbindungspunkt zwischen der Ansteuerdiode D5 und der Z-Diode D4 liegt die Reihenschaltung einer Diode D1 und eines Widerstandes R1, wobei die Diode D1 in bezug auf die Kollektorspannung in Sperrichtung gepolt ist. Der Verbindungspunkt zwischen der Ansteuerdiode D5 und der Z-Diode D4 ist über einen Thyristor D3 als Halbleiterschalter mit dem Emitter des Schalttransistors V1 verbunden. Das Gitter des Thyristors D3 wird über eine weitere Z-Diode D2 durch die Spannung zwischen Widerstand R1 und Diode D1 angesteuert. Zur Verzögerung dieser Spannung ist zwischen dem Bezugspotential und dem Verbindungspunkt zwischen dem Widerstand R1 und der Diode D1 ein Kondensator C1 angeordnet. Der Verbindungspunkt zwischen Z-Diode D4 und Diode D6 ist mit einer in Bezug auf die Kollektorspannung in Sperrichtung gepolte Antisättigungsdiode D7 zum Kollektor des Schalttransistors V1 überbrückt. Der Kollektor des Schalttransistors V1 liegt über einen Lastwiderstand $R_L$ an der Lastspannung $U_L$.

Wenn der Ansteuertransistor V2 eingeschaltet wird, so fließt durch die Primärwicklung des Übertragers T1 ein konstanter Strom $I_E$, der auf die Sekundärseite des Übertragers T1 als Strom $I_A$ transformiert wird. Der Strom $I_A$ fließt über die Diode D5, die Z-Diode D4 und die Diode D6 in die Basis-Emitterstrecke des Schalttransistors V1, der dadurch einschaltet. Die Antisättigungsdiode D7 ist vorgesehen, um bei zu hoher Basis-Emitterspannung den Strom $I_A$ über die Kollektor-Emitterstrecke abzuleiten und damit eine Übersättigung des Transistors V1 zu verhindern. An dem durch den Widerstand R1 und die Diode D1 gebildeten Spannungsteiler steht an der Widerstandsseite die Summe der Zenerspannung der Z-Diode D4, der Durchlaßspannung der Diode D6 und der Basis-Emitterspannung des Schalttransistors V1 an. An der Diode D1 steht die Kollektor-Emitterspannung $U_A$ des Schalttransistors V1 an. Die Kollektor-Emitterspannung $U_A$ des Schalttransistors V1 hängt vom Laststrom $I_L$ ab. Solange dieser nicht zu groß wird, bleibt auch die Kollektor-Emitterspannung $U_A$

klein, so daß die zwischen dem Widerstand R1 und der Diode D1 abgegriffene Spannung unter der Zenerspannung der Z-Diode D2 liegt. Damit wird der Thyristor D3 nicht durchgesteuert. Steigt dagegen der Laststrom $I_L$ an, so wird auch die Kollektor-Emitterspannung $U_A$ größer, bis schließlich die Spannung am Verbindungspunkt zwischen dem Widerstand R1 und der Diode D1 die Zenerspannung der Z-Diode D2 übersteigt und damit der Thyristor D3 gezündet wird. Dabei fließt der Ansteuerstrom $I_A$ des Übertragers T1 über den Thyristor D3, so daß der Schalttransistor V1 sperrt und der Überstrom beseitigt ist. Der Thyristor D3 bleibt solange leitend, bis der Ansteuerstrom $I_A$ verschwindet. Wenn beim nächsten Einschalten des Schalttransistors V1 die Überlastungsursache noch nicht beseitigt ist, so erfolgt wiederum eine Abschaltung des Schalttransistors V1.

Beim Einschaltvorgang wird mit dem Ansteuerstrom $I_A$ sofort die Spannung am Verbindungspunkt zwischen der Diode D5 und der Z-Diode D4 aufgebaut. Der Schalttransistor V1 leitet dagegen im ersten Moment noch nicht, so daß eine hohe Kollektor-Emitterspannung $U_A$ ansteht. Um zu verhindern, daß diese hohe Spannung zu einem Durchsteuern des Thyristors D3 und damit zu einer unerwünschten Ableitung des Ansteuerstroms $I_A$ führt, ist ein Kondensator C1 vorgesehen, der zusammen mit dem Widerstand R1 ein RC-Glied bildet, das den Spannungsanstieg an der Z-Diode D2 verzögert.

Die Spannung $U_E$ auf der Primärseite des Übertragers T1 ist von der Spannung auf der Sekundärseite abhängig. Wenn der Thyristor D3 durchgeschaltet hat, wird die Spannung $U_E$ sehr klein. Diese Tatsache wird in der Schaltung nach der Figur zur Anzeige für das Ansprechen des Überlastschutzes ausgewertet. Dazu ist ein Komparator K vorgesehen, der die Spannung $U_E$ auf der Primärseite des Übertragers T1 mit einer Referenzspannung $U_{REF}$ vergleicht. Der Komparator K liefert an seinen Ausgang dann ein Störsignal, wenn die Spannung $U_E$ unter der Referenzspannung $U_{REF}$ liegt, d. h. wenn der Thyristor D3 durchgezündet ist.

Mit der beschriebenen Schaltung ist es also auf einfache Weise möglich, einen Transistor zuverlässig gegen Überlastung zu schützen. Dabei ist weder eine gesonderte Hilfsspannung noch ein Verluste verursachender Widerstand im Lastkreis erforderlich. Das Ansprechen der Überwachungsschaltung kann unter Beibehaltung der Potentialtrennung zwischen Primär- und Sekundärseite auf der Primärseite des Übertragers angezeigt werden.

## Ansprüche

1. Schutzschaltung für einen über einen Übertrager (T1) angesteuerten Schalttransistor (V1) mit einem zur Basis-Emitter-Strecke parallel liegenden Halbleiterschalter (D3), der bei Überstrom in der Kollektor-Emitter-Strecke des Schalttransistors (V1) eingeschaltet wird, wobei zwischen Basis und Kollektor des Schalttransistors (V1) die Reihenschaltung eines Widerstandes (R1) und einer Diode (D1) angeordnet ist, die in bezug auf die Kollektorspannung des Schalttransistors (V1) in Sperrichtung gepolt ist, und wobei der Verbindungspunkt zwischen Widerstand (R1) und Diode (D1) über einen Kondensator (C1) mit dem Bezugspotential der Schaltungsanordnung und über ein Schwellwertglied (D2) mit dem Steuereingang des Halbleiterschalters (D3) verbunden ist, dadurch gekennzeichnet, daß jeder Ansteuerimpuls auf der Primärseite des Übertragers (T1) mit einer Referenzspannung verglichen wird, und daß bei Unterschreitung der Referenzspannung ein Störsignal abgegeben wird.

2. Schutzschaltung nach Anspruch 1, dadurch gekennzeichnet, daß zwischen dem Widerstand (R1) und der Basis des Schalttransistors (V1) eine Z-Diode (D4) angeordnet ist.

## Claims

1. Protective circuit for a switching transistor (V1) which is triggered via a transformer (T1), comprising a semiconductor switch (D3) which is connected in parallel with the base-to-emitter path of the switching transistor (V1) and which is switched-on in the event of excess current in the collector-to-emitter path of the switching transistor (V1), there being arranged between the base and collector of the switching transistor (V1) the series connection of a resistance (R1) and a diode (D1) which is poled in a reverse direction in respect of the collector voltage of the switching transistor (V1), and the point of connection between the resistance (R1) and diode (D1) being connected via a capacitor (C1) to the reference potential of the circuit arrangement and via a threshold value member (D2) to the control input of the semiconductor switch (D3), characterised in that each trigger impulse on the primary side of the transformer (T1) is compared to a reference voltage, and in that a disturbance signal is emitted in the event of a fall below the reference voltage.

2. Protective circuit according to claim 1, characterised in that a zener-diode (D4) is arranged between the resistance (R1) and the base of the switching transistor (V1).

## Revendications

1. Circuit de protection pour un transistor de commutation (V1) commandé par l'intermédiaire d'un transistor (T1) qui comporte un commutateur à semiconducteurs (D3) en parallèle sur le circuit base-émetteur qui est rendu conducteur lors d'une surintensité dans le circuit collecteur-émetteur du transistor de commutation (V1), le montage série d'une résistance (R1) et d'une diode (D1), qui est polarisée dans le sens de blocage par rapport à la tension de collecteur du transistor de commutation (V1), étant disposé entre la base et le collecteur du transistor de commutation (V1), et le point de jonction entre la résistance (R1) et la diode (D1) étant relié, par l'intermédiaire d'un condensateur (C1), au potentiel de référence du circuit et, par l'intermédiaire d'un élément à seuil (D2), à l'entrée de commande du commutateur à semiconducteurs (D3), caractérisé par le fait que chaque impulsion de commande du côté primaire du transformateur (T1) est comparée à une tension de référence, et qu'un signal de perturbation est délivré lorsque la tension de référence n'est pas atteinte.

2. Circuit de protection suivant la revendication 1, caractérisé par le fait qu'une diode Zener (D4) est disposée entre la résistance (R1) et la base du transistor de commutation (V1).